# EUROPÄISCHE PATENTSCHRIFT

(11) **EP 3 335 017 B1**
(45) Veröffentlichungstag und Bekanntmachung des Hinweises auf die Patenterteilung: **01.07.2020**
(21) Anmeldenummer: 16750656.7
(22) Anmeldetag: 26.07.2016
(51) Int. Cl.: G01F 23/284, G01S 13/88, H01Q 13/24, G01S 7/03, H01Q 1/12, H01Q 1/22, H01P 5/107

(54) **RADAR-FÜLLSTANDSMESSGERÄT**
RADAR LEVEL MEASURING DEVICE
DISPOSITIF DE MESURE DE NIVEAU RADAR

(30) Priorität: 11.08.2015 DE 102015113224
(43) Veröffentlichungstag der Anmeldung: 20.06.2018
(73) Patentinhaber: Endress+Hauser SE+Co. KG, 79689 Maulburg (DE)
(72) Erfinder: SEILER, Christian, 79424 Auggen (DE); BLÖDT, Thomas, 79585 Steinen (DE); FÜGLISTALLER, Jörg, CH-8967 Widen (CH)
(74) Vertreter: Andres, Angelika Maria
(86) Internationale Anmeldenummer: PCT/EP2016/067727
(87) Internationale Veröffentlichungsnummer: WO 2017/025313

(56) Entgegenhaltungen:
- EP-A1- 2 506 363
- DE-A1-102005 054 233
- DE-T5-112004 001 988
- DE-T5-112004 001 988
- US-A1- 2011 158 344

## Beschreibung

Die Erfindung bezieht sich auf ein Radar-Füllstandsmessgerät zur Messung eines Füllstands eines Füllgutes in einem Behälter nach dem Laufzeitprinzip.

Bei der Füllstandsmessung werden Mikrowellen mittels einer Antenne zur Oberfläche eines Füllguts gesendet und die an der Oberfläche reflektierten Echowellen empfangen. Es wird eine die Echoamplituden als Funktion der Entfernung darstellende Echofunktion gebildet, aus der das wahrscheinliche Nutzecho und dessen Laufzeit bestimmt werden. Aus der Laufzeit wird der Abstand zwischen der Füllgutoberfläche und der Antenne bestimmt.

In der industriellen Messtechnik werden regelmäßig dielektrische Stabantennen und Hornantennen zum Senden und/oder Empfangen eingesetzt. Typischerweise wird ein Gehäuse verwendet, das einen Gehäuseabschnitt aufweist, der die Geometrie eines kurzgeschlossenen Hohlleiters besitzt.

In dem Gehäuseabschnitt mit der Hohlleitergeometrie ist ein Koppelelement eingeführt, über das Mikrowellen durch den Gehäuseabschnitt hindurch gesendet und/oder empfangen werden. Die Mikrowellen werden beim Senden von einem entfernt angeordneten Mikrowellengenerator erzeugt und über Koaxialleitungen zu einer Sende-/Empfangseinrichtung transportiert. In der Antenne erfolgt über die Sende-/Empfangseinrichtung eine Umwandlung von zugeführten leitungsgebundenen Mikrowellen in Mikrowellen, die sich im freien Raum ausbreiten, und umgekehrt.

Zur Bestimmung des Füllstandes können alle bekannten Verfahren angewendet werden, die es ermöglichen, verhältnismäßig kurze Entfernungen mittels reflektierter Mikrowellen zu messen. Die bekanntesten Beispiele sind das Pulsradar und das Frequenzmodulations-Dauerstrichradar (FMCW-Radar).

WO01/88488 A1 beschreibt (siehe Fig. 1) ein Füllstandsmessgerät mit einer Stabantenne 35. Die Stabantenne 35 umfasst einen zylindrischen Hohlleiter 39, der mittels einer Rückwand 37 an einem Ende kurzgeschlossenen ist. Das Füllstandsmessgerät weist eine Platine 49 auf, auf der sich ein Mikrowellengenerator 45 befindet. Die Platine 49 weist einen Abschnitt 51 auf, der durch eine Ausnehmung 52 in dem Hohlleiter 39 seitlich in die Stabantenne 35 eingeführt ist. Der Abschnitt 51 ist parallel zu der Rückwand 37 und von dieser beabstandet angeordnet. Das Sende-/Empfangselement 47 ist auf dem in die Stabantenne 35 hineinragenden Abschnitt 51 angeordnet.

Bei dem Radar-basierten Füllstandsmessgerät, das in der internationalen Veröffentlichungsschrift DE 112004001988 T5 gezeigt wird, ist die Platine, auf der sich das Sende-/Empfangselement befindet, zwischen dem Hohlleiter und einem Abschlussdeckel, der die Rückwand des Hohlleiters bildet, angeordnet.

Ein Gerät, das zur Radar-basierten Übertragung digitaler Daten zwischen einzelnen Platinen dient, ist in der Veröffentlichungsschrift US 2011/0158344 A1 gezeigt. Bei dem dortigen Gerät wird der Abschlussdeckel mittels Verschrauben am Hohlleiter befestigt, wobei auch dort die Platinen mit dem Sende-/Empfangselement zwischen dem Abschlussdeckel und dem Hohlleiter angeordnet sind.

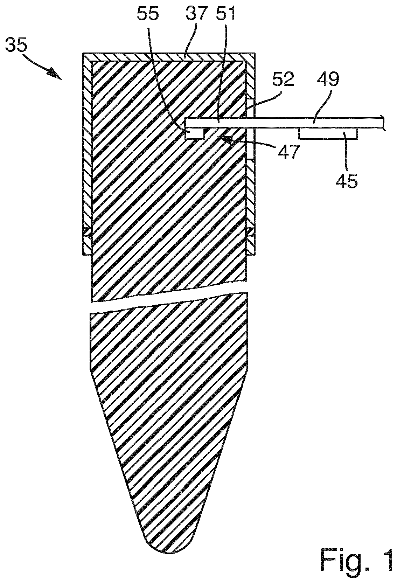

Der Abstand zwischen dem Sende-/Empfangselement und der Rückwand muss in einem bestimmten Wertebereich liegen. Dieser Wertebereich hängt entscheidend von der Wellenlänge der Mikrowellen ab. Nachteilig an einem aus dem Stand der Technik bekannten Füllstandsmessgerät (siehe Fig. 1) ist, dass im Laufe der Zeit oder beim Vergießen des Gehäuses die Platine sich verschieben kann und das Sende-/Empfangselement seinen Abstand zur Rückwand ändern kann. Dies führt zu einer destruktiven Überlagerung und folglich zu intensitätsschwachen abgestrahlten Mikrowellen, wodurch die Messgenauigkeit des Füllstandsmessgeräts beeinträchtig wird.

Der Erfindung liegt die Aufgabe zugrunde, ein Füllstandsmessgerät bereitzustellen, das genaue Werte für den Füllstand ermittelt.

Die Aufgabe wird durch den Gegenstand der Erfindung gelöst. Die Erfindung ist durch den unabhängigen Anspruch 1 definiert. Die spezifischen Ausführungsformen der Erfindung sind durch die abhängigen Ansprüche 2 bis 7 definiert. Der Gegenstand der Erfindung ist ein Radar-Füllstandsmessgerät zur Messung eines Füllstands eines Füllgutes in einem Behälter nach dem Laufzeitprinzip, umfassend eine Leiterplatte mit einer Sende-/Empfangseinrichtung zum Senden und Empfangen von hochfrequenten Radarwellen und einer Auswerteeinheit zum Bestimmen der Laufzeit der von einer Oberfläche des Füllguts reflektierten Radarwellen, wobei die Leiterplatte mindestens zwei Öffnungen aufweist, wobei die Sende-/Empfangseinrichtung ein Koppelelement zum Aus- und Einkoppeln der Radarwellen aufweist, wobei ein Ende des Koppelelements an einer ersten Seite der Leiterplatte mittig zwischen den mindestens zwei Öffnungen angeordnet ist, ein Hohlleiter mit mindestens zwei randseitigen Vorsprüngen, die als Verlängerung an einem Ende des Hohlleiters parallel zur Längsachse des Hohlleiters ausgestaltet sind, wobei die Längen der mindestens zwei Vorsprünge größer sind als die Dicke der Leiterplatte, wobei die mindestens zwei Vorsprünge durch die mindestens zwei Öffnungen durchgeführt sind, so dass die mindestens zwei Vorsprünge zum Teil aus einer zweiten Seite der Leiterplatte herausragen, ein Abschlussdeckel, der an den Teilen der mindestens zwei Vorsprünge, die aus der zweiten Seite der Leiterplatte herausragen, befestigt ist, so dass der Hohlleiter mittels des Abschlussdeckels an die Leiterplatte befestigt ist.

Ein erfindungsgemäßes Radar-Füllstandsmessgerät ist einfacher zu montieren als das aus dem Stand der Technik bekannte. Darüber hinaus ist im montierten Zustand die Leiterplatte relativ zum Hohlleiter und relativ zum Abschlussdeckel unbeweglich und ändert Ihren Abstand zum Abschlussdeckel im Laufe der Zeit nicht. Beträgt der Abstand zwischen dem Koppelelement auf der Leiterkarte und der Rückwand ein ganzzahliges Vielfaches der Hälfte der Wellenlänge der erzeugten Radarwellen, ist die Intensität der Radarwellen und somit die Messgenauigkeit des Radar-Füllstandsmessgeräts maximal.

Gemäß einer vorteilhaften Weiterbildung ist der Hohlleiter als ein Hornstrahler ausgestaltet.

Gemäß einer vorteilhaften Variante mündet der Hohlleiter an einem der Leiterplatte gegenüberliegenden Ende in einen Hornstrahler.

Gemäß einer vorteilhaften Ausführungsform weist der Abschlussdeckel mindestens zwei Aussparungen auf, wobei die mindestens zwei Aussparungen dermaßen ausgestaltet sind, dass die mindestens zwei Aussparungen eine formschlüssige Verbindung mit den Teilen der mindestens zwei Vorsprünge eingehen, die aus der zweiten Seite der Leiterplatte herausragen.

Gemäß einer vorteilhaften Ausgestaltung ist der Abschlussdeckel kongruent zu einer Oberfläche der Leiterplatte und zu den Teilen der mindestens zwei Vorsprünge, die aus der zweiten Seite der Leiterplatte herausragen, ausgestaltet, so dass Radarwellen nicht nach außerhalb des Hohlleiters oder des Abschlussdeckels gelangen.

Gemäß einer günstigen Weiterbildung weist der Hohlleiter einen kreisförmigen, elliptischen, rechteckigen oder quadratischen Querschnitt auf.

Die Erfindung wird anhand der nachfolgenden Zeichnungen näher erläutert. Es zeigt:
Fig. 1: zeigt eine schematische Darstellung eines Radar-Füllstandsmessgeräts nach dem Stand der Technik, bei dem die Sende-/Empfangseinheit eine senkrecht zur Senderichtung verlaufende Mikrostreifenleitung aufweist,
Fig. 2: zeigt eine schematische Explosionsdarstellung eines erfindungsgemäßen Radar-Füllstandsmessgeräts, bei dem der Hohlleiter an einer Leiterplatte montiert wird, und
Fig. 3: zeigt eine schematische Seitenansicht eines montierten Radar-Füllstandsmessgeräts entsprechend Fig. 2.

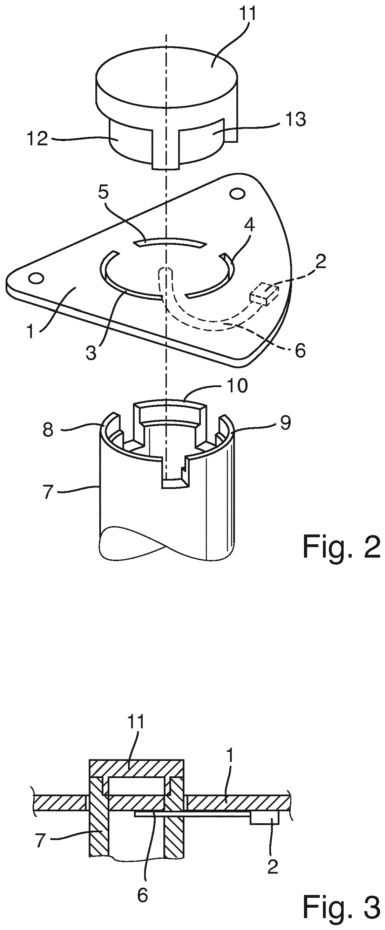

Fig. 2 zeigt eine schematische Explosionsdarstellung eines erfindungsgemäßen Radar-Füllstandsmessgeräts (nicht dargestellt) zur Messung eines Füllstands eines Füllgutes in einem Behälter nach dem Laufzeitprinzip. Das Radar-Füllstandsmessgerät umfasst eine Leiterplatte 1, auf dem eine Sende-/Empfangseinrichtung 2 zum Senden und Empfangen von hochfrequenten Radarwellen und eine Auswerteeinheit (nicht dargestellt) zum Bestimmen der Laufzeit der von einer Oberfläche des Füllguts reflektierten Radarwellen, angeordnet sind. Die Leiterplatte 1 weist drei Öffnungen 3, 4, 5 auf, die länglich ausgestaltet sind und dermaßen gebogen auf der Leiterkarte 1 verlaufen, dass sie einen Kreis bilden. Die Sende-/Empfangseinrichtung 2 weist ein Koppelelement 6 zum Aus- und Einkoppeln der Radarwellen auf, welches ebenfalls auf der Leiterplatte 1 angeordnet ist.

Ein freies Ende des Koppelelements 6 ist an einer ersten Seite der Leiterplatte 1 mittig zwischen den drei Öffnungen 3, 4, 5 angeordnet.

Ein Hohlleiter 7 des Radar-Füllstandsmessgeräts weist drei randseitige Vorsprünge 8, 9, 10 auf, die als Verlängerung eines Endes des Hohlleiters 7 parallel zur Längsachse des Hohlleiters 7 ausgestaltet sind. Die Längen der drei Vorsprünge 8, 9, 10 sind größer als die Dicke der Leiterplatte 1. Die drei Vorsprünge 8, 9, 10 sind durch die drei Öffnungen 3, 4, 5 durchführbar, so dass die drei Vorsprünge 8, 9, 10 zum Teil aus einer zweiten Seite der Leiterplatte 1 herausragen.

Ein Abschlussdeckel 11 weist an einem Ende randseitig drei Aussparungen 12, 13 auf (die dritte Aussparung ist nicht dargestellt). Die drei Aussparungen 12, 13 des Abschlussdeckels 11 sind dermaßen ausgestaltet, dass sie eine formschlüssige Verbindung mit den drei Vorsprüngen 8, 9, 10 des Hohlleiters 7 eingehen können.

Das Montieren des Radar-Füllstandsmessgeräts läuft folgendermaßen ab. Zuerst werden die drei Vorsprünge 8, 9, 10 des Hohlleiters 7 durch die Öffnungen 3, 4, 5 der Leiterplatte 1 durchgeführt, bis ein Teil der Vorsprünge 8, 9, 10 auf einer gegenüberliegenden Seite der Leiterplatte 1 herausragt. Anschließend wird der Abschlussdeckel 11 auf der zweiten Seite der Leiterplatte in die herausragenden Teile der Vorsprünge 8, 9, 10 geschoben, bis die drei Aussparungen 11, 12 des Abschlussdeckels 11 eine formschlüssige Verbindung mit den drei Vorsprüngen 8, 9, 10 des Hohlleiters 7 eingehen.

Fig. 3 zeigt ein montiertes Radar-Füllstandsmessgerät entsprechend Fig. 1.

### Bezugszeichenliste

- 1: Leiterplatte
- 2: Sende-/Empfangseinrichtung
- 3: Erste Öffnung
- 4: Zweite Öffnung
- 5: Dritte Öffnung
- 6: Koppelelement
- 7: Hohlleiter
- 8: Erster Vorsprung
- 9: Zweiter Vorsprung
- 10: Dritter Vorsprung
- 11: Abschlussdeckel
- 12: Erste Aussparung
- 13: Zweite Aussparung

## Patentansprüche

1. Radar-Füllstandsmessgerät zur Messung eines Füllstands eines Füllgutes in einem Behälter nach dem Laufzeitprinzip, umfassend
einen Hohlleiter (7),
einen Abschlussdeckel (11), und
eine Leiterplatte (1) mit einer Sende-/Empfangseinrichtung (2) zum Senden und Empfangen von hochfrequenten Radarwellen und einer Auswerteeinheit zum Bestimmen der Laufzeit der von einer Oberfläche des Füllguts reflektierten Radarwellen, wobei die Sende-/Empfangseinrichtung (2) ein Koppelelement (6) zum Aus- und Einkoppeln der Radarwellen aufweist,
**dadurch gekennzeichnet, dass**
die Leiterplatte (1) mindestens zwei Öffnungen (3, 4) aufweist, wobei ein Ende des Koppelelements (6) an einer ersten Seite der Leiterplatte (1) mittig zwischen den mindestens zwei Öffnungen (3, 4) angeordnet ist,
wobei der Hohlleiter (7) mindestens zwei randseitige Vorsprünge (8, 9), die als Verlängerung an einem Ende des Hohlleiters (7) parallel zur Längsachse des Hohlleiters (7) ausgestaltet sind, umfasst, wobei die Längen der mindestens zwei Vorsprünge (8, 9) größer sind als die Dicke der Leiterplatte (1), wobei die mindestens zwei Vorsprünge (8, 9) durch die mindestens zwei Öffnungen (3, 4) durchgeführt sind, so dass die mindestens zwei Vorsprünge (8, 9) zum Teil aus einer zweiten Seite der Leiterplatte (1) herausragen, und wobei der Abschlussdeckel (11) in die Teile der mindestens zwei Vorsprünge (8, 9), die aus der zweiten Seite der Leiterplatte (1) herausragen, schiebbar ist, so dass der Hohlleiter (7) mittels des Abschlussdeckels (11) an die Leiterplatte (1) befestigt ist.

2. Radar-Füllstandsmessgerät nach Anspruch 1, wobei der Hohlleiter (7) als ein Hornstrahler ausgestaltet ist.

3. Radar-Füllstandsmessgerät nach Anspruch 1, wobei der Hohlleiter (7) an einem der Leiterplatte (1) gegenüberliegenden Ende in einen Hornstrahler mündet.

4. Radar-Füllstandsmessgerät nach einem der vorhergehenden Ansprüche, wobei der Abschlussdeckel (11) mindestens zwei Aussparungen (12, 13) aufweist, wobei die mindestens zwei Aussparungen (12, 13) dermaßen ausgestaltet sind, dass die mindestens zwei Aussparungen (12, 13) eine formschlüssige Verbindung mit den Teilen der mindestens zwei Vorsprünge (8, 9) eingehen, die aus der zweiten Seite der Leiterplatte (1) herausragen.

5. Radar-Füllstandsmessgerät nach Anspruch 4, wobei der Abschlussdeckel (11) kongruent zu einer Oberfläche der Leiterplatte (1) und zu den Teilen der mindestens zwei Vorsprünge (8, 9), die aus der zweiten Seite der Leiterplatte (1) herausragen, ausgestaltet ist, so dass Radarwellen nicht nach außerhalb des Hohlleiters (7) oder des Abschlussdeckels (11) gelangen.

6. Radar-Füllstandsmessgerät nach einem der vorhergehenden Ansprüche, wobei der Hohlleiter (7) einen kreisförmigen, elliptischen, rechteckigen oder quadratischen Querschnitt aufweist.

7. Radar-Füllstandsmessgerät nach einem der vorhergehenden Ansprüche, wobei die Leiterplatte (1) aus mindestens zwei Lagen aufgebaut ist, wobei mindestens einer der zwei Lagen einen für Hochfrequenzwellen verlustarmen Material, insbesondere PEEK, PFTE, PP, PE oder Teflonkeramik aufweist, die bevorzugt in die Richtung des Hohlleiter (7) zeigt.

## Claims

1. Radar level transmitter designed to measure a level of a medium in a vessel according to the transit time principle, comprising
a waveguide (7),
an end cover (11), and
a printed circuit board (1) with a transmission/reception unit (2) designed to transmit and receive high-frequency radar waves, and an evaluation unit designed to determine the transit time of the radar waves reflected by a surface of the medium, wherein the transmission/reception unit (2) has a coupling element (6) to couple and decouple the radar waves,
**characterized in that**
the printed circuit board (1) has at least two openings (3, 4), wherein one end of the coupling element (6) is arranged on a first side of the printed circuit board (1) centrally between the at least two openings (3, 4), wherein the waveguide (7) comprises at least two side projections (8, 9) which are designed as an extension at one end of the waveguide (7) parallel to the longitudinal axis of the waveguide (7), wherein the lengths of the at least two projections (8, 9) are greater than the thickness of the printed circuit board (1), wherein the at least two projections (8, 9) pass through the at least two openings (3, 4) in such a way that the at least two projections (8, 9) partially project out of a second side of the printed circuit board (1), and wherein the end cover (11) can be moved into the parts of the at least two projections (8, 9) that project out of the second side of the printed circuit board (1) in such a way that the waveguide (7) is fixed on the printed circuit board (1) by means of the end cover (11).

2. Radar level transmitter as claimed in Claim 1, wherein the waveguide (7) is designed as a horn antenna.

3. Radar level transmitter as claimed in Claim 1, wherein the waveguide (7) enters into a horn antenna at an end opposite the printed circuit board (1).

4. Radar level transmitter as claimed in one of the previous claims, wherein the end cover (11) has at least two recesses (12, 13), wherein the at least two recesses (12, 13) are designed in such a way that the at least two recesses (12, 13) form a positive-locking connection with the parts of the at least two projections (8, 9) that project out of the second side of the printed circuit board (1).

5. Radar level transmitter as claimed in Claim 4, wherein the end cover (11) is designed in a manner that it is congruent to a surface of the printed circuit board (1) and to the parts of the at least two projections (8, 9) that project out of the second side of the printed circuit board (1) such that radar waves do not go outside the waveguide (7) or the end cover (11).

6. Radar level transmitter as claimed in one of the previous claims, wherein the waveguide (7) has a circular, elliptical, rectangular or square cross-section.

7. Radar level transmitter as claimed in one of the previous claims, wherein the printed circuit board (1) is made from at least two layers, wherein at least one of the two layers features a material with minimum losses for high-frequency waves, particularly PEEK, PFTE, PP, PE or Teflon ceramic, said layer being preferably oriented in the direction of the waveguide (7).

## Revendications

1. Transmetteur de niveau radar destiné à la mesure d'un niveau d'un produit dans un réservoir selon le principe du temps de parcours, comprenant
un guide d'ondes (7),
un couvercle de fermeture (11), et
une carte de circuit imprimé (1) avec un dispositif d'émission / de réception (2) destiné à l'émission et à la réception d'ondes radar haute fréquence, et une unité d'exploitation destinée à la détermination du temps de parcours des ondes radar réfléchies sur une surface du produit, le dispositif d'émission / de réception (2) comportant un élément de couplage (6) destiné au découplage et au couplage des ondes radar,
**caractérisé**
**en ce que** la carte de circuit imprimé (1) présente au moins deux ouvertures (3, 4), une extrémité de l'élément de couplage (6) étant disposée sur une première face de la carte de circuit imprimé (1) de manière centrale entre les au moins deux ouvertures (3, 4), le guide d'ondes (7) comprenant au moins deux saillies de bord (8, 9) prévues en tant que prolongement à une extrémité du guide d'ondes (7) parallèlement à l'axe longitudinal du guide d'ondes (7), les longueurs des au moins deux saillies (8, 9) étant supérieures à l'épaisseur de la carte de circuit imprimé (1), les au moins deux saillies (8, 9) passant à travers les au moins deux ouvertures (3, 4) de sorte que les au moins deux saillies (8, 9) font partiellement saillie d'une deuxième face de la carte de circuit imprimé (1), et le couvercle de fermeture (11) pouvant coulisser dans les parties des au moins deux saillies (8, 9) qui dépassent de la deuxième face de la carte de circuit imprimé (1), de sorte que le guide d'ondes (7) est fixé à la carte de circuit imprimé (1) au moyen du couvercle de fermeture (11).

2. Transmetteur de niveau radar selon la revendication 1, pour lequel le guide d'ondes (7) est conçu en tant qu'antenne à cornet.

3. Transmetteur de niveau radar selon la revendication 1, pour lequel le guide d'ondes (7) débouche, à l'extrémité opposée de la carte de circuit imprimé (1), dans une antenne à cornet.

4. Transmetteur de niveau radar selon l'une des revendications précédentes, pour lequel le couvercle de fermeture (11) présente au moins deux évidements (12, 13), les au moins deux évidements (12, 13) étant conçus de telle sorte que les au moins deux évidements (12, 13) forment une liaison par complémentarité de forme avec les parties des au moins deux saillies (8, 9) qui dépassent de la deuxième face de la carte de circuit imprimé (1).

5. Transmetteur de niveau radar selon la revendication 4, pour lequel le couvercle de fermeture (11) est conçu de façon congruente à une surface de la carte de circuit imprimé (1) et aux parties des au moins deux saillies (8, 9), qui dépassent de la deuxième face de la carte de circuit imprimé (1), de telle sorte que les ondes radar ne parviennent pas vers l'extérieur du guide d'ondes (7) ou du couvercle de fermeture (11).

6. Transmetteur de niveau radar selon l'une des revendications précédentes, pour lequel le guide d'ondes (7) présente une section circulaire, elliptique, rectangulaire ou quadratique.

7. Transmetteur de niveau radar selon l'une des revendications précédentes, pour lequel la carte de circuit imprimé (1) est constituée d'au moins deux couches, au moins l'une des deux couches étant constituée d'un matériau à faibles pertes pour les ondes à haute fréquence, notamment du PEEK, du PFTE, du PP, du PE ou une céramique de téflon, laquelle couche est orientée de préférence dans la direction du guide d'ondes (7).
